# FASCICULE DE BREVET EUROPEEN

(11) **EP 3 249 491 B1**
(45) Date de publication et mention de la délivrance du brevet: **14.10.2020**
(21) Numéro de dépôt: 16201128.2
(22) Date de dépôt: 29.11.2016
(51) Int. Cl.: G05F 1/59, G05F 1/56

(54) **DISPOSITIF DE RÉGULATION À FAIBLE CHUTE DE TENSION, EN PARTICULIER CAPABLE DE SUPPORTER DES TENSIONS D'ALIMENTATION COMPATIBLES AVEC LA NORME USB TYPE C**
VORRICHTUNG ZUM REGULIEREN EINES SCHWACHEN SPANNUNGSABFALLS, DIE INSBESONDERE IN DER LAGE IST, VERSORGUNGSSPANNUNGEN ZU UNTERSTÜTZEN, DIE MIT DER USB-NORM TYP C KOMPATIBEL SIND
LOW DROP OUT REGULATOR, IN PARTICULAR CAPABLE TO BE SUPPLIED WITH SUPPLY VOLTAGES COMPATIBLE WITH TYPE C USB STANDARD

(30) Priorité: 23.05.2016 FR 1654576
(43) Date de publication de la demande: 29.11.2017
(73) Titulaire: STMicroelectronics (ALPS) SAS, 38000 Grenoble (FR)
(72) Inventeur: PONS, Alexandre, 38220 Vizille (FR)
(74) Mandataire: Casalonga

(56) Documents cités:
- EP-A1- 0 838 745
- EP-A1- 2 905 859
- US-A1- 2010 060 078
- US-B1- 6 177 783

## Description

Des modes de réalisation de l'invention concernent les dispositifs de régulation à faible chute de tension (« LDO » : « Low Drop Out voltage regulator » en langue anglaise) et plus particulièrement ceux compatibles avec la norme USB type C. De tels dispositifs sont décrits par exemple dans EP0838745 et US6177783.

La norme USB type C est une nouvelle norme USB offrant de nouvelles caractéristiques, à savoir notamment une orientation réversible du connecteur USB et de la direction du câble USB. Par ailleurs, le câble USB peut supporter des puissances élevées, pouvant aller jusqu'à 60 watts par exemple, dans des applications de chargement, ce qui implique des tensions d'alimentation élevées, typiquement de 5 volts à 20 volts. Cela étant, d'autres tensions d'alimentation plus faibles sont également possibles, par exemple de 2,7 volts à 5,5 volts.

Les contrôleurs type C sont utilisés pour gérer la détection du câble USB (connexion et type), le protocole de communication, et les différentes tensions d'alimentation.

Des contrôleurs type C identiques peuvent être situés à l'intérieur de la source (le bloc d'alimentation, typiquement un chargeur de batterie que l'on branche sur le secteur) mais aussi à l'intérieur de l'objet qui consomme la puissance (un téléphone mobile, un ordinateur portable, une tablette, ...) ou encore à l'intérieur des connecteurs des câbles USB par exemple.

Or les tensions d'alimentation présentes dans ces différentes situations sont généralement de valeurs différentes.

Selon un mode de réalisation, il est par conséquent proposé un régulateur à faible chute de tension embarqué qui puisse être alimenté par de multiples sources d'alimentation de façon à générer une tension d'alimentation fixe pour le contrôleur selon la revendication 1.

Selon un mode de réalisation, il est proposé de réaliser un tel régulateur avec un encombrement réduit et utilisant un transistor PMOS de puissance uniquement lorsque la haute tension d'alimentation est sélectionnée et utilisant des transistors PMOS classiques pour les autres tensions d'alimentation.

Selon un aspect, il est ainsi proposé un dispositif de régulation à faible chute de tension, comprenant un amplificateur d'erreur et un étage de puissance ayant une borne de sortie rebouclée sur l'amplificateur d'erreur et apte à délivrer un courant de sortie dans une charge.

Selon une caractéristique générale de cet aspect, le dispositif de régulation comprend plusieurs entrées principales d'alimentation destinées à potentiellement recevoir respectivement plusieurs tensions d'alimentation différentes.

L'étage de puissance comprend plusieurs chemins de conduction (« power path ») respectivement connectés entre lesdites entrées principales d'alimentation et ladite borne de sortie, individuellement sélectionnables et comportant chacun un transistor de sortie (ou transistor de « gain »).

Le terme « plusieurs » s'entend comme signifiant « au moins deux » .

Le dispositif de régulation comprend en outre un circuit de sélection connecté auxdites entrées principales d'alimentation et configuré pour sélectionner l'un des chemins de conduction en fonction d'un critère de sélection.

L'amplificateur d'erreur comporte par ailleurs un étage de sortie (comportant par exemple un étage de gain « petits signaux ») configuré pour piloter sélectivement le transistor de sortie du chemin de conduction sélectionné.

Selon un mode de réalisation, l'amplificateur d'erreur comporte un étage d'entrée possédant une entrée couplée à ladite borne de sortie, et l'étage de sortie comporte plusieurs modules respectivement affectés au chemin de conduction, chaque module étant couplé à la sortie de l'étage d'entrée, à l'entrée principale d'alimentation connectée au chemin de conduction correspondant, et configuré pour piloter ou non le transistor de sortie du chemin de conduction correspondant sur commande du circuit de sélection.

Selon un mode de réalisation, chaque module comporte
une entrée de module couplée à la sortie de l'étage d'entrée de l'amplificateur d'erreur,
une sortie de module couplée à la grille du transistor de sortie correspondant,
une entrée d'alimentation de module couplée à l'entrée principale d'alimentation correspondante, et
un étage de gain connecté entre l'entrée d'alimentation de module et la masse et comportant un transistor de module connecté entre la sortie de module et la masse et dont la grille est connectée à l'entrée de module et à la masse par l'intermédiaire respectivement de deux interrupteurs respectivement commandables par deux signaux de commande complémentaires délivrés par le circuit de sélection.

Chaque module comprend avantageusement un circuit de compensation de Miller, connecté entre le drain et la grille du transistor de module.

Selon un mode de réalisation, le circuit de sélection est alimenté par la tension de sortie présente à ladite borne de sortie et le dispositif de régulation possède une configuration de démarrage dans laquelle chaque chemin de conduction connecté à une tension d'alimentation effectivement présente, est passant jusqu'à ce que ladite tension de sortie atteigne une valeur seuil permettant au circuit de sélection de sélectionner l'un des chemins de conduction.

Par ailleurs, chaque module de l'étage de sortie de l'amplificateur d'erreur est avantageusement configuré pour, dans ladite configuration de démarrage, rendre passant le transistor de sortie correspondant.

Chaque transistor de sortie est par exemple un transistor PMOS ayant son substrat connecté vers l'entrée principale d'alimentation correspondante et chaque module comprend avantageusement un circuit d'excursion basse (« pull down ») connecté entre la sortie de module et la masse et possédant une entrée de commande connectée à ladite borne de sortie.

Ce circuit d'excursion basse comprend par exemple
un premier transistor NMOS connecté entre la sortie de module et la masse,
une résistance connectée entre l'entrée d'alimentation de module et la grille du premier transistor,
un deuxième transistor NMOS connecté entre la grille du premier transistor et la masse et dont la grille est connectée à ladite borne de sortie.

Selon un mode de réalisation, chaque chemin de conduction comporte un moyen commandable par le circuit de sélection et configuré pour permettre la sélection ou non du chemin de conduction et pour rendre passant le chemin de conduction pendant la phase de démarrage.

Ce moyen commandable comprend par exemple un transistor auxiliaire PMOS monté en diode, connecté entre le transistor de sortie et la borne de sortie, et commandable sur sa grille par l'intermédiaire d'un transistor de commande lui-même commandable sur sa grille par le circuit de sélection.

Ce transistor auxiliaire PMOS a par ailleurs avantageusement son substrat connecté vers la borne de sortie et sa grille connectée à la borne de sortie par l'intermédiaire d'une résistance.

Selon un mode de réalisation, le circuit de sélection comprend plusieurs circuits de détection respectivement couplés aux entrées principales d'alimentation et configurés chacun pour détecter le franchissement d'un seuil par la tension d'alimentation correspondante et délivrer un signal logique de détection représentatif du franchissement ou non dudit seuil.

Le circuit de sélection comporte par ailleurs un module logique configuré pour recevoir les signaux logiques de détection et pour délivrer un signal de sélection représentatif du chemin de conduction sélectionné en fonction dudit critère de sélection.

Ce critère de sélection peut correspondre avantageusement à la tension d'alimentation présente présentant la plus faible valeur.

L'amplificateur d'erreur pourrait être alimenté avec une tension d'alimentation distincte mais il est particulièrement avantageux qu'il soit alimenté par la tension d'alimentation délivrée à la borne de sortie du dispositif de régulation.

En d'autres termes, l'étage d'entrée de l'amplificateur d'erreur possède une entrée d'alimentation avantageusement connectée à la borne de sortie.

L'un au moins des transistors de sortie est avantageusement un transistor spécifique compatible « haute tension », par exemple un transistor de puissance, de façon à pouvoir supporter une haute tension d'alimentation.

Selon un autre aspect il est proposé un contrôleur, compatible avec la norme USB type C, incorporant un dispositif de régulation à faible chute de tension tel que défini ci-avant.

Selon un autre aspect il est proposé un appareil, par exemple un ordinateur portable, ou encore un appareil de communication sans fil tel que par exemple un téléphone mobile cellulaire ou une tablette, incorporant un contrôleur tel que défini ci-avant.

Selon un autre aspect, il est proposé un chargeur de source d'alimentation continue, par exemple un chargeur de batterie, incorporant un contrôleur tel que défini ci-avant.

Il est encore proposé, selon un autre aspect, un câble USB de type C, incorporant un contrôleur tel que défini ci-avant.

D'autres avantages et caractéristiques de l'invention apparaîtront à l'examen de la description détaillée de modes de réalisation, nullement limitatifs, et des dessins annexés sur lesquels :

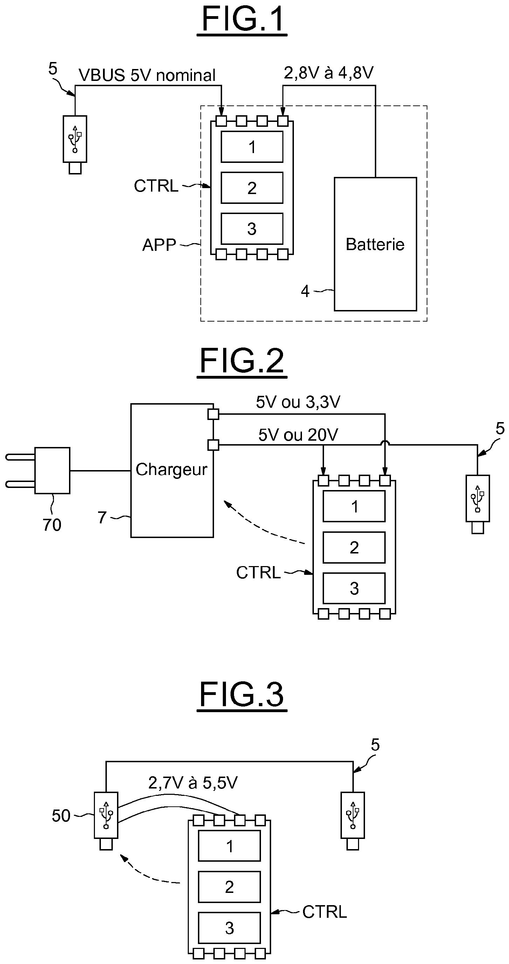

- les figures 1 à 10 ont trait à différents modes de réalisation de l'invention.

Sur les figures 1 à 3, la référence CTRL désigne un contrôleur USB compatible avec la norme USB type C comportant un ou typiquement plusieurs régulateurs à faible chute de tension 1 (LDO) destinés à délivrer une tension régulée fixe à un module analogique frontal (AFE : Analogue Front end) 2 de structure classique et connue en soi, ainsi qu'à un cœur numérique 3.

Dans le mode de réalisation de la figure 1, le contrôleur CTRL est disposé dans un appareil APP, par exemple un ordinateur portable ou bien un appareil de communication sans fil tel qu'un téléphone mobile cellulaire, ou encore une tablette numérique.

Dans cet exemple, le contrôleur peut être alimenté soit par une haute tension VBUS délivrée par un câble USB type C référencé 5, ayant par exemple un niveau de 5 volts nominal mais pouvant varier de 5 volts à 20 volts typiquement, ou alors par une tension VBAT délivrée par une source d'alimentation continue 4, par exemple une batterie, cette tension VBAT pouvant par exemple varier entre 2,8 volts et 4,8 volts.

Dans le mode de réalisation de la figure 2, le contrôleur CTRL est incorporé dans un chargeur 7, par exemple un chargeur de batterie, possédant une fiche 70 destinée à être connectée au secteur. Le chargeur 7 est par exemple configuré pour alimenter le régulateur 1 avec une haute tension VBUS (de 5 volts à 20 volts) qui pourra être véhiculée sur le câble USB 5, ou alors avec une tension auxiliaire dont le niveau peut être par exemple de 5 volts ou de 3,3 volts.

Dans le mode de réalisation de la figure 3, le contrôleur CTRL est disposé dans le câble USB 5, et plus particulièrement dans chaque connecteur 50 et peut être alors alimenté par une tension auxiliaire provenant d'une première broche du connecteur (par exemple la broche normalisée sous la dénomination CC1) ou par une autre tension auxiliaire provenant d'une deuxième broche du connecteur (par exemple la broche normalisée sous la dénomination CC2), dont les niveaux peuvent varier de 2,7 volts à 5,5 volts par exemple.

On voit donc que le régulateur 1 à faible chute de tension doit être capable de délivrer une tension régulée fixe aux différents éléments du contrôleur CTRL quelle que soit la valeur de la tension d'alimentation du régulateur qui peut provenir de plusieurs sources d'alimentation différentes.

Le régulateur 1 incorporé dans le contrôleur CTRL est donc un régulateur à faible chute de tension qui peut être alimenté à partir de sources d'alimentation multiples pour générer une tension régulée fixe en sortie.

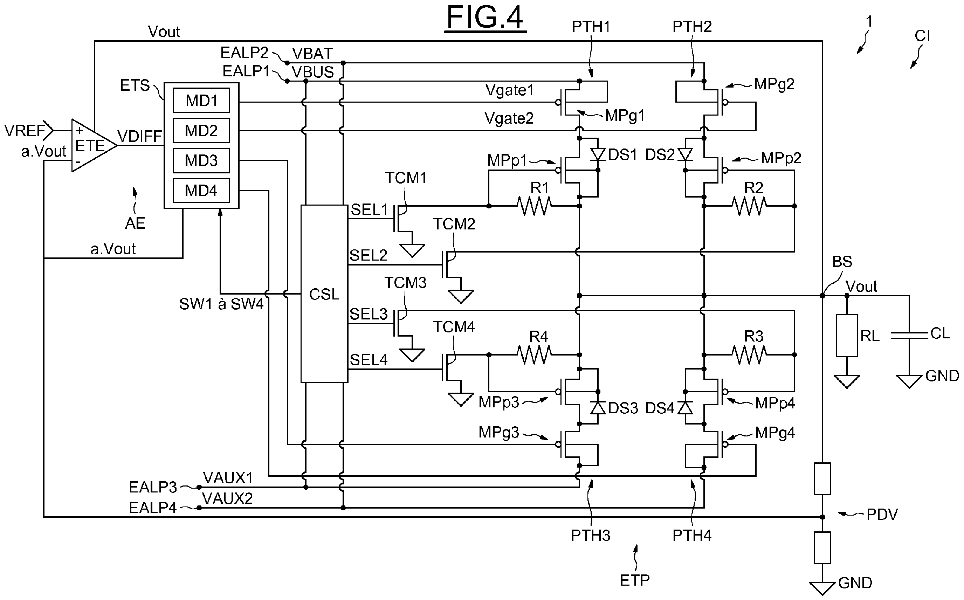

On va maintenant décrire plus particulièrement, en se référant aux figures 4 à 10, un mode de réalisation et un exemple de fonctionnement d'un tel régulateur 1.

Si l'on se réfère maintenant plus particulièrement à la figure 4, on voit que le régulateur 1, réalisé par exemple de façon intégrée au sein d'un circuit intégré CI, comporte un amplificateur d'erreur AE recevant une tension de référence VREF issue d'une source de tension de référence, par exemple une source de tension de référence de bande interdite (band gap reference voltage) qui est une tension sensiblement indépendante de la température et qui délivre une tension aux alentours de 1,25 volts, voisine de la valeur de bande interdite du silicium à la température de 0 K qui est égale à 1,22 électronvolts.

Le régulateur 1 comporte également un étage de puissance ETP ayant une borne de sortie BS rebouclée sur l'amplificateur d'erreur par l'intermédiaire d'un pont diviseur PDV (bien que ce pont diviseur ne soit pas absolument indispensable) de façon à délivrer sur l'entrée inverseuse de l'amplificateur d'erreur une tension égale à a.Vout où Vout est la tension de sortie délivrée à la borne de sortie du régulateur et a le rapport de division du pont diviseur PDV.

La tension de sortie Vout est une tension régulée, c'est-à-dire indépendante des variations de la tension d'alimentation qui, dans le cas présent, peut être l'une des tensions VBUS, VBAT, VAUX1 et VAUX2 susceptibles d'être disponibles.

Pour des raisons de stabilité, le régulateur 1 peut être connecté à un condensateur de découplage CL. Par ailleurs sur cette figure 4, la référence RL représente la charge du régulateur qui peut être par exemple le module analogique frontal (AFE : Analogue Front end) 2 ou le cœur numérique 3 (figures 1 à 3).

Dans ce mode de réalisation, le régulateur 1 comporte par conséquent quatre entrées principales d'alimentation EALP1-EALP4 destinées à potentiellement recevoir respectivement plusieurs tensions d'alimentation différentes, en l'espèce les tensions VBUS, VBAT, VAUX1 et VAUX2.

Comme on le verra plus en détail ci-après, une seule de ces tensions d'alimentation peut être présente ou bien plusieurs tensions d'alimentation peuvent être présentes simultanément.

La tension VBUS est ici une haute tension pouvant varier typiquement de 5 volts à 20 volts tandis que la tension VBAT est une tension basse pouvant varier par exemple de 2,8 volts à 4,8 volts et que les tensions VAUX1 et VAUX2 sont des tensions moyennes pouvant varier par exemple de 2,7 volts à 5,5 volts.

L'étage de puissance ETP du régulateur 1 comprend plusieurs chemins de conduction, au moins deux et ici quatre chemins de conduction, PTH1-PTH4 respectivement connectés entre les entrées principales d'alimentation EALP1-EALP4 et la borne de sortie BS.

Ces chemins de conduction PTH1-PTH4 sont individuellement sélectionnables et comportent chacun un transistor de sortie MPgi (i variant de 1 à 4).

Le régulateur 1 comporte par ailleurs un circuit de sélection CSL connecté aux entrées principales d'alimentation EALP1-EALP4 et configuré pour sélectionner l'un des chemins de conduction PTH1-PTH4 en fonction d'un critère de sélection dont on donnera un exemple ci-après.

Enfin, l'amplificateur d'erreur AE comporte outre l'étage d'entrée ETE recevant la tension de référence VREF et la tension a.Vout, un étage de sortie ETS configuré pour piloter sélectivement le transistor de sortie MPgi du chemin de conduction sélectionné PTHi.

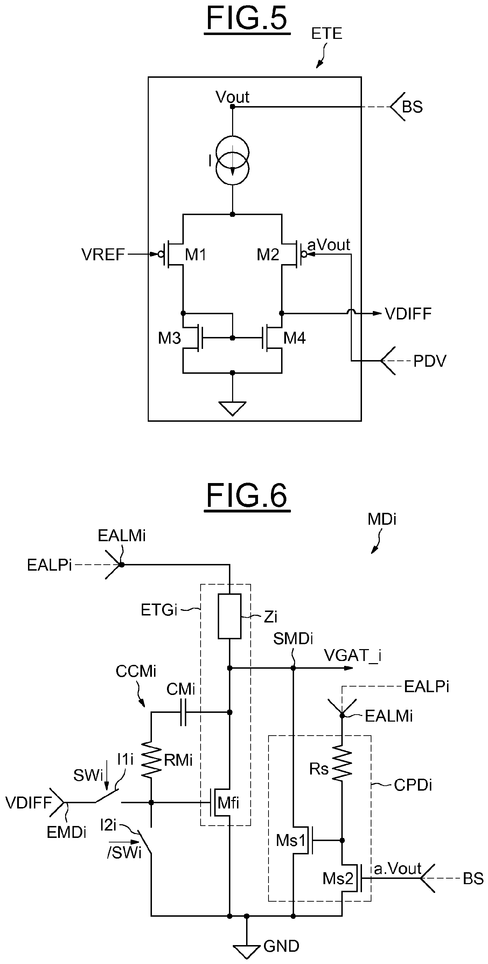

On se réfère maintenant plus particulièrement aux figures 5 à 8 pour décrire plus en détail les différents éléments de ce régulateur 1.

Si l'on se réfère maintenant plus particulièrement à la figure 5, on voit que l'étage d'entrée ETE de ce régulateur peut être réalisé de façon classique par une paire différentielle polarisée par une source de courant I alimentée par la tension Vout délivrée à la borne de sortie BS du régulateur.

La paire différentielle est connectée sur un miroir de courant.

La paire différentielle comprend deux transistors PMOS M1 et M2 reliés par leur source.

Le miroir de courant est formé par deux transistors M3 et M4 reliés par leurs grilles, par exemple des transistors NMOS. Les sources des transistors M3 et M4 sont respectivement connectées sur les drains des transistors M1 et M2 de la paire différentielle.

La grille du transistor M1 correspond à l'entrée positive de l'amplificateur d'erreur AE et reçoit donc la tension de référence VREF.

La grille du transistor M2 correspond à l'entrée inverseuse de l'amplificateur et reçoit la tension a.Vout.

Le drain du transistor M2 forme la sortie de cet étage d'entrée ETE et fournit une tension VDIFF.

L'étage de sortie ETS comporte plusieurs modules, ici quatre modules MD1-MD4 (figure 4) respectivement affectés aux chemins de conduction PTH1-PTH4.

Chaque module MDi est couplé à la sortie de l'étage d'entrée de l'amplificateur d'erreur AE et est également couplé à l'entrée principale d'alimentation EALPi connectée au chemin de conduction correspondant PTHi.

Chaque module est configuré pour piloter ou non le transistor de sortie MPgi du chemin de conduction correspondant PTHi sur commande du circuit de sélection CSL.

On se réfère maintenant plus particulièrement à la figure 6 pour décrire plus en détail un exemple de réalisation d'un module MDi.

L'architecture de tous les modules MDi est identique. Seules les valeurs de certains composants changent pour s'adapter notamment aux caractéristiques du transistor de sortie correspondant.

Chaque module MDi comporte une entrée de module EMDi couplée à la sortie de l'étage d'entrée ETE de l'amplificateur d'erreur AE pour recevoir la tension VDIFF.

Le module MDi comporte également une sortie de module SMDi couplée à la grille du transistor de sortie correspondant MPgi. La sortie de module SMDi délivre le signal Vgate_i.

Le module MDi comporte une entrée d'alimentation de module EALMi couplée à l'entrée principale d'alimentation correspondante EALPi.

Le module MDi comporte par ailleurs un étage de gain en montage source commune ETGi, connecté entre l'entrée d'alimentation de module EALMi et la masse GND.

Cet étage de gain (petit signal) comporte un transistor de module Mfi, ici un transistor NMOS, connecté entre la sortie de module SMDi et la masse GND. La grille de ce transistor de module Mfi est connectée à l'entrée de module EMDi par l'intermédiaire d'un premier interrupteur I1i commandé par un signal de commande SWi.

La grille du transistor de module Mfi est également reliée à la masse GND par l'intermédiaire d'un deuxième interrupteur I2i commandé par un signal de commande /SWi, complémentaire du signal de commande SWi.

L'étage de gain comporte en outre une résistance Zi, dont la valeur forme la valeur de l'impédance de sortie de l'étage de gain, connectée entre la sortie de module SMDi et l'entrée d'alimentation de module EALMi.

Comme on le verra plus en détail ci-après, le circuit de sélection CSL est alimenté par la tension de sortie présente à la borne de sortie et le dispositif de régulation 1 possède une configuration de démarrage dans laquelle chaque chemin de conduction PTHi connecté à une tension d'alimentation effectivement présente, est passant jusqu'à ce que la tension de sortie Vout atteigne une valeur seuil permettant au circuit de sélection CSL d'entrer en fonctionnement et de sélectionner l'un des chemins de conduction en fonction du critère de sélection.

A cet égard, chaque module MDi est configuré pour, dans cette configuration de démarrage, rendre passant le transistor de sortie correspondant MPgi.

A cet effet, chaque transistor de sortie MPgi étant un transistor PMOS, chaque module comprend un circuit d'excursion basse (circuit de « pull down ») CPDi connecté entre la sortie de module SMDi et la masse GND.

Plus précisément, ce circuit de « pull down » CPDi comprend
un premier transistor NMOS Ms1 connecté entre la sortie de module SMDi et la masse GND,
une résistance Rs connectée entre l'entrée d'alimentation de module EALMi et la grille du premier transistor Ms1,
un deuxième transistor Ms2 connecté entre la grille du premier transistor Ms1 et la masse, et dont la grille, formant une entrée de commande pour ce circuit de pull down, est connectée à la borne de sortie BS pour recevoir, via le pont diviseur PDV, la tension aVout.

Comme on le verra plus en détail ci-après, pendant la phase de démarrage, ce circuit CPDi assure que le signal Vgate_i est tiré vers la masse en présence de la tension d'alimentation correspondante, tant que le circuit de sélection n'est pas opérationnel, de façon à rendre passant le transistor PMOS de sortie MPgi pendant cette phase de démarrage.

Enfin, bien que ce ne soit pas indispensable, le module MDi comporte un circuit de compensation de Miller, de structure classique, connecté entre le drain et la grille du transistor de module Mfi.

Ce circuit de compensation de Miller CCMi comporte un condensateur CMi connecté en série avec une résistance RMi.

Le circuit de compensation de Miller permet d'améliorer la stabilité de la boucle de contre-réaction reliant la borne de sortie BS à l'entrée inverseuse du premier étage ETE de l'amplificateur d'erreur AE.

Les valeurs du condensateur CMi et de la résistance RMi sont déterminées de façon classique en fonction des caractéristiques du transistor de sortie correspondant MPgi, des caractéristiques de l'étage d'entrée de l'amplificateur d'erreur et de la plage de variations de la charge de sortie.

On se réfère maintenant de nouveau à la figure 4 pour décrire plus en détail l'architecture de l'étage de puissance ETP.

Celui-ci comporte autant de chemins de conduction PTHi que de sources d'alimentation potentielles et donc d'entrées d'alimentation principale AELPi.

Cet étage de puissance ETP est configuré de façon à permettre une gestion directe de ces chemins de conduction multiples de façon à en sélectionner un seul à l'issue de la phase de démarrage, et ce sans utiliser une structure classique qui utiliserait un seul chemin de conduction en combinaison avec plusieurs commutateurs classiques permettant de sélectionner la tension d'alimentation souhaitée.

L'architecture de chaque chemin de conduction étant identique, on ne décrira ici qu'un seul de ces chemins de conduction, par exemple le chemin de conduction PTH1.

Le chemin de conduction PTH1 comporte le transistor de sortie ou transistor de gain MPg1 qui est ici un transistor PMOS travaillant dans sa région de saturation avec le substrat connecté vers l'entrée principale d'alimentation EALP1.

Le chemin de conduction PTH1 comporte par ailleurs un transistor auxiliaire PMOS MPp1, ou transistor de protection, monté en diode (sa grille est reliée à son drain par l'intermédiaire d'une résistance R1). La référence DS1 désigne la diode de substrat intrinsèque à ce transistor qui participe au fonctionnement du transistor en diode lors de la phase de démarrage. Cette diode DS1 est passante du fait de la connexion du substrat du transistor MPp1 vers la borne de sortie BS et, dans le cas d'un transistor PMOS, elle est constituée par la zone de drain dopée P et la zone de substrat dopée N.

Ce transistor auxiliaire MPp1 est connecté entre le transistor de sortie MPg1 et la borne de sortie BS et, lorsque le chemin de conduction est sélectionné, il fonctionne dans sa région linéaire avec son substrat connecté à la borne de sortie BS. Dans la phase de démarrage il fonctionne en diode comme indiqué précédemment.

Ce transistor auxiliaire MPp1 est commandable sur sa grille par l'intermédiaire de la résistance R1 (qui permet le montage en diode du transistor) et d'un transistor de commande TCM1 qui est lui-même commandable sur sa grille par un signal de commande SEL1 délivré par le circuit de sélection CSL.

Dans l'exemple décrit ici, parmi les quatre chemins de conduction PTH1-PTH4,
un chemin, à savoir le chemin PTH1, est un chemin haute tension dédié à l'alimentation VBUS,
un autre chemin, à savoir le chemin PTH2, est un chemin basse tension dédié à l'alimentation VBAT délivrée par une batterie, et
les deux autres chemins à savoir les chemin PTH3 et PTH4 sont des chemins moyenne tension dédiés à des alimentations auxiliaires VAUX1 et VAUX2.

De ce fait, le seul composant spécifique haute tension est le transistor de sortie MPg1 qui est par exemple un transistor PMOS de puissance du type à drain étendu. Tous les autres transistors PMOS sont des transistors classiques réalisables en technologie CMOS.

Dans une architecture classique de régulateur utilisant un seul chemin de conduction en combinaison par exemple avec quatre interrupteurs commandables destinés à sélectionner une tension d'alimentation parmi quatre tensions d'alimentation possibles, il serait nécessaire d'avoir cinq transistors de puissance, à savoir quatre transistors de puissance pour les quatre interrupteurs dédiés aux quatre tensions d'alimentation possibles (que l'alimentation soit une alimentation haute tension ou non) et un transistor de puissance pour le chemin de conduction.

L'invention permet donc ici d'économiser quatre transistors de puissance, ce qui permet une réduction avantageuse de l'encombrement surfacique du régulateur.

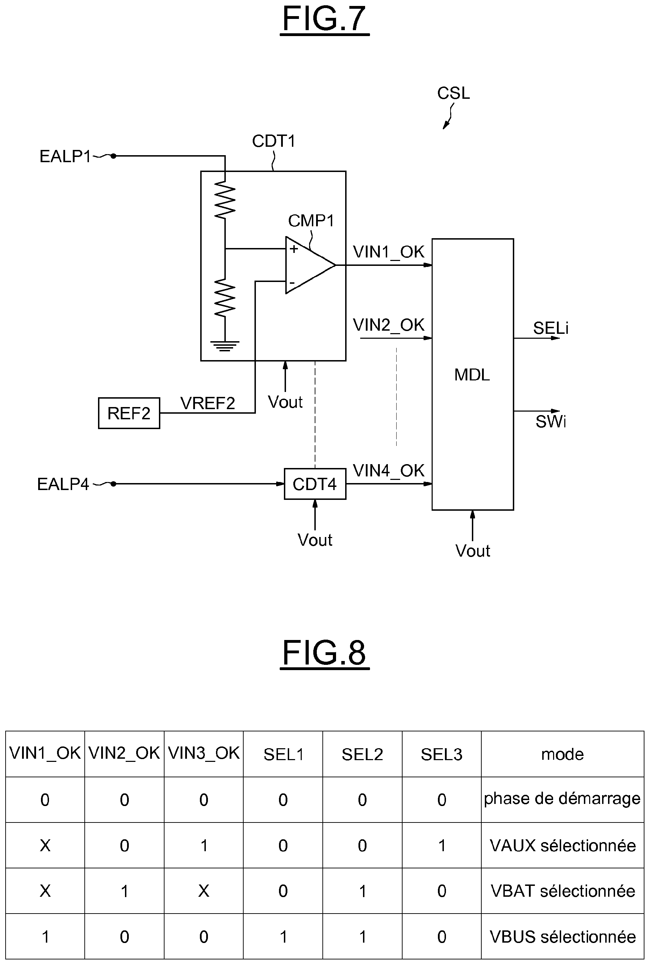

On se réfère maintenant plus particulièrement à la figure 7 pour décrire la structure du circuit de sélection CSL.

Le circuit de sélection CSL comprend plusieurs circuits de détection CDT1-CDT4 respectivement couplés au circuit principal d'alimentation EALP1-EALP4.

Chaque circuit de détection CDTi est configuré pour détecter le franchissement d'un seuil par la tension d'alimentation correspondante présente éventuellement à l'entrée principale d'alimentation EALPi et délivrer un signal logique de détection VINi_OK représentatif du franchissement ou non de ce seuil.

Chaque circuit de détection comporte un comparateur CMPi dont l'entrée non inverseuse est reliée à l'entrée principale d'alimentation correspondante par l'intermédiaire d'un pont diviseur de tension et dont l'entrée inverseuse reçoit une tension de référence VREF2 issue d'une source de tension de référence REF2.

Cette tension de référence VREF2 peut être identique ou différente de la tension VREF reçue sur l'entrée non inverseuse de l'étage d'entrée ETE de l'amplificateur d'erreur AE.

Les différents comparateurs CMP1-CMP4 sont alimentés par la tension Vout disponible à la borne de sortie BS du régulateur.

Outre les circuits de détection CDTi, le circuit de sélection comporte un module logique MDL, également alimenté par la tension Vout, recevant tous les signaux logiques de détection VINi_OK et configuré pour délivrer d'une part les signaux de commande SELi aux transistors de commande TCMi (figure 4) et d'autre part les signaux de commande SWi au module MDi de l'étage de sortie ETS.

Les signaux de commande SELi et SWi forment ensemble des signaux de sélection permettant de sélectionner l'un des chemins de conduction et « d'ouvrir » les autres chemins.

Chaque signal logique VINi_OK prend la valeur 1 lorsque la tension d'alimentation devient supérieure à VREF2 /b, où b est le rapport de division du pont diviseur associé.

Sinon, le signal logique VINi_OK garde la valeur 0.

Le module logique MDL comporte un ensemble de portes logiques dont la structure est définie à partir du critère de sélection souhaité, sachant qu'un seul signal de commande SELi doit être actif (égal à 1) à la fois.

Le critère de sélection peut être le suivant.

Si une seule tension d'alimentation est présente, cette tension doit être sélectionnée.

Si plusieurs tensions d'alimentation sont présentes, on choisira celle présentant la plus faible valeur, ce qui permet de minimiser la puissance consommée.

Un exemple de schéma de sélection est illustré sur la figure 8, schéma pour lequel on considère que le régulateur 1 comporte trois entrées principales d'alimentation EALP1-EALP3 destinées respectivement à potentiellement recevoir la haute tension d'alimentation VBUS, la basse tension d'alimentation VBAT et une tension moyenne d'alimentation VAUX.

Dans la phase de démarrage, aucune tension d'alimentation n'est encore présente, et les trois signaux logique VIN1_OK, VIN2_OK et VIN3_OK sont à 0 de même que les trois signaux de commande SEL1-SEL3.

Dès que la tension VAUX a franchi son seuil (VIN3_OK=1) alors le module logique MDL est configuré pour conférer la valeur logique 1 au signal de commande SEL3 et la valeur logique 0 aux signaux de commande SEL1 et SEL2, si le signal logique VIN2_OK est nul et ce quelle que soit la valeur logique du signal VIN1_OK.

En d'autres termes, la tension VAUX sera alors sélectionnée, que cette tension soit la seule présente ou qu'elle soit présente simultanément à la tension VBUS, puisque l'on sélectionne la tension ayant la plus faible valeur.

De même, dès que le signal logique de détection VIN2_OK prend la valeur logique 1, alors le module logique MDL est configuré pour conférer la valeur logique 1 au signal de commande SEL2 et la valeur logique 0 aux signaux de commande SEL1 et SEL3, et ce quelle que soit la valeur logique des signaux VIN1_OK et VIN3_OK.

En d'autres termes, c'est cette fois-ci la tension VBAT qui sera sélectionnée, qu'elle soit seule ou en présence des deux autres tensions d'alimentation puisqu'elle est la tension la plus faible.

Enfin, en présence de signaux logiques VIN2_OK et VIN3_OK égaux à 0, le signal de commande SEL1 prendra la valeur 1 dès que le signal logique de détection VIN1_OK prendra la valeur 1, ce qui correspond à la sélection de la tension d'alimentation VBUS qui est alors considérée comme étant la seule alimentation disponible.

Par ailleurs, tant qu'un signal de commande SELi est à 0, le signal SWi est à 0 maintenant ouvert l'interrupteur I1i (figure 6) tandis que le signal /SWi est à 1, fermant l'interrupteur I2i pour relier la grille du transistor Mfi à la masse.

On va maintenant décrire un mode de fonctionnement du régulateur selon l'invention.

Dans la phase de démarrage, tous les chemins de conduction sont actifs c'est-à-dire qu'un chemin de conduction est capable d'être passant dès la montée de la tension d'alimentation correspondante effectivement présente à l'entrée de ce chemin de conduction.

En effet, si l'on considère le chemin de conduction PTHi, dès que la valeur de la tension d'alimentation associée à ce chemin de conduction, initialement à 0, augmente, le circuit de « pull down » CPDi du module MDi (figure 6) tire la grille du transistor de sortie MPgi correspondant à la masse (Vgate_i est tiré à 0).

En effet, la tension aVout présente sur la grille du transistor Ms2 n'est pas suffisante pour rendre ce transistor passant. Ce transistor est donc bloqué et la résistance Rs est choisie de façon à ce que la tension présente à la grille du transistor Ms1 soit supérieure à la tension de seuil de ce transistor pour le rendre passant, connectant par conséquent la grille du transistor de sortie MPgi à la masse.

Le transistor MPgi est par conséquent passant.

Par ailleurs, bien que le transistor auxiliaire MPpi soit bloqué puisque le signal de commande SELi correspondant est à 0, le courant peut circuler à travers ce transistor puisqu'il est monté en diode.

Ainsi, dès qu'une tension d'alimentation monte, celle-ci commence à charger le condensateur de sortie CL à travers le transistor de sortie MPgi correspondant et à travers la diode du transistor auxiliaire MPpi.

La tension de sortie Vout suit alors la différence entre la valeur de cette tension d'alimentation diminuée de la tension de seuil de la diode. Et, il n'y a aucun risque de courant inverse en raison du transistor auxiliaire monté en diode et des diodes substrats DSi de ces transistors auxiliaires disposées tête-bêche.

Dès que la tension de sortie Vout atteint une valeur seuil, par exemple une valeur seuil égale à la valeur d'un système de « power-on reset » (par exemple entre 1,2 et 1,5 volts) le circuit de sélection CSL alimenté par cette tension Vout peut fonctionner et déterminer quel chemin sélectionner.

A cet égard, le signal de commande SELi correspondant au chemin sélectionné prend la valeur 1, ce qui rend passant le transistor de commande TCMi (figure 4), ce qui tire par conséquent à la masse la grille du transistor auxiliaire MPpi de façon à le rendre totalement passant.

Par ailleurs, le transistor Ms2 du module MDi devient passant, ce qui bloque le transistor Ms1. Par contre, le signal SWi prend la valeur 1, ce qui ferme l'interrupteur I1i et ouvre l'interrupteur I2i, rendant passant le transistor de module Mfi. La boucle de régulation est alors active via l'amplificateur d'erreur AE. La grille du transistor MPgi est tirée à un potentiel garantissant la régulation de la tension de sortie à la tension de consigne. Il convient de noter que ce mécanisme fonctionne même si plusieurs tensions d'alimentation démarrent au même instant. Ainsi, comme expliqué ci-avant, tant que la tension de sortie Vout n'atteint pas son seuil, le circuit de sélection est inopérant mais les chemins correspondant aux tensions d'alimentation effectivement présentes qui montent en même temps, sont passants et la tension de sortie Vout suit la tension d'alimentation la plus élevée diminuée de la tension de seuil de la diode. Dès que la tension de sortie Vout devient supérieure au seuil, le circuit de sélection opère et rend passant le chemin de conduction sélectionné tout en ouvrant les autres chemins de conduction.

Et, comme le régulateur fonctionne en permanence, si à un instant donné la configuration des tensions d'alimentation présentes aux entrées principales est modifiée, le circuit de sélection peut sélectionner une autre tension d'alimentation associée à un autre chemin de conduction.

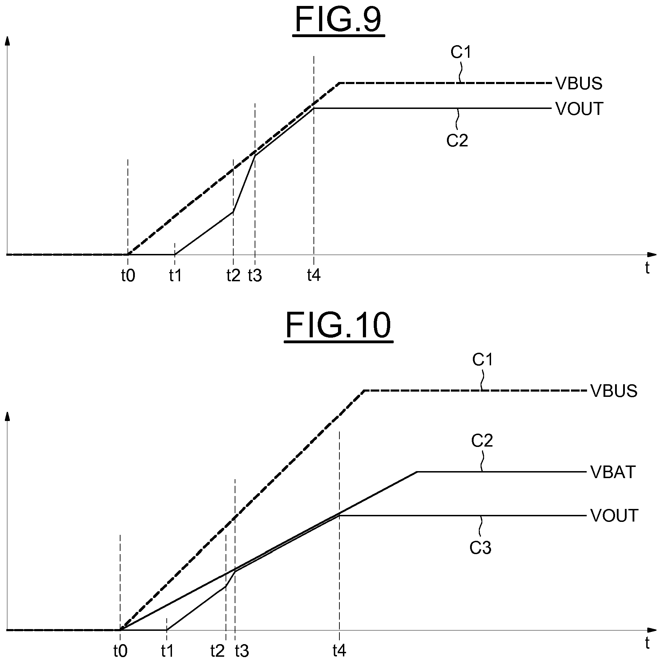

Ces mécanismes de fonctionnement sont illustrés sur deux exemples (figure 9 et figure 10).

Sur la figure 9, on suppose que seule la haute tension VBUS est présente.

Sur la figure 9, la courbe C1 illustre l'évolution temporelle de la tension VBUS tandis que la courbe C2 illustre l'évolution temporelle de la tension de sortie Vout.

A l'instant t0, la tension VBUS commence à monter. Compte tenu du transistor monté en diode dans le chemin de conduction correspondant, la tension Vout commence à monter à l'instant t1 pour suivre la tension VBUS à la tension de seuil de diode près.

Puis, à l'instant t2, la tension de sortie Vout a atteint son seuil permettant au circuit de sélection de fonctionner. Celui-ci sélectionne alors le chemin de conduction associé à la tension VBUS ce qui permet à la tension Vout de rejoindre la tension VBUS à l'instant t3. Entre l'instant t3 et t4 la tension Vout rejoint la tension de consigne imposée par la tension de référence VREF (c'est-à-dire la tension de consigne égale à VREF/a) et au-delà de l'instant t4, on a la phase de régulation.

Sur la figure 10, on suppose que les tensions VBUS et VBAT sont disponibles simultanément.

Sur cette figure 10, la courbe C1 illustre l'évolution temporelle de la tension VBUS, la courbe C2 illustre l'évolution temporelle de la tension VBAT et la courbe C3 illustre l'évolution temporelle de la tension Vout.

A l'instant t0, les deux tensions VBUS et VBAT commencent à monter.

En raison des transistors correspondants montés en diodes, la tension Vout suit la tension d'alimentation la plus élevée, en l'espèce la tension VBUS, à la valeur de seuil de diode près.

Puis, à l'instant t2, le circuit de sélection entre en fonctionnement et il sélectionne le chemin de conduction associé à la tension VBAT qui est la tension la plus faible.

La tension Vout rejoint alors à l'instant t3 la tension VBAT puis entre les instants t3 et t4 suit cette tension VBAT jusqu'à atteindre la valeur de consigne. La phase de régulation linéaire se poursuit au-delà de l'instant t4.

De façon à obtenir une bonne performance du régulateur (en termes de PSSR : « Power Supply Rejection Ratio ») dans des conditions de faible chute de tension, il est recommandé de maintenir le transistor de sortie MPgi correspondant dans sa région de saturation même dans les conditions d'alimentation minimale.

Les conditions de fonctionnement du transistor étant les suivantes :
*Vt < Vgs < Vds* + *Vt,*
cela conduit à une surface du transistor MPgi proportionnelle à l'inverse de la racine carrée de la chute de tension. Aussi, une forte chute de tension sur le transistor haute tension a un impact majeur sur la réduction de la surface.

On obtient ainsi une diminution de l'encombrement surfacique du régulateur dans un rapport 2 à 3 par rapport à une architecture classique à un seul chemin de conduction.

L'invention n'est pas limitée aux modes de réalisation qui viennent d'être décrits.

Ainsi, on pourrait éventuellement utiliser à la place du circuit de « pull down » dans le module MDi, un montage comparateur qui recevrait sur son entrée non inverseuse la tension d'alimentation et une tension de référence sur son entrée inverseuse. Par ailleurs, d'autres architectures sont possibles pour l'étage de sortie ETS telles que par exemple des montages push-pull ou bien l'utilisation d'étages tampons (buffer).

Cela étant, l'architecture décrite ci-avant présente l'avantage que lorsque les alimentations sont présentes au démarrage, le circuit de sélection est éteint. Et lorsque les alimentations sont suffisantes pour alimenter le circuit de sélection (tension de sortie suffisante), le circuit de sélection couple les alimentations non utilisées (définies par le critère de sélection) et ne conserve que l'alimentation destinée à alimenter le contrôleur USB.

On évite ainsi des états inconnus avec des commutateurs ouverts, ce qui permet des démarrages prédictifs et sains.

Par ailleurs, le circuit de sélection étant alimenté par la sortie du régulateur, il n'a pas à gérer de haute tension, ce qui simplifie sa réalisation (utilisation de transistors classiques).

## Revendications

1. Dispositif de régulation à faible chute de tension, comprenant un amplificateur d'erreur (AE) et un étage de puissance (ETP) ayant une borne de sortie (BS) rebouclée sur l'amplificateur d'erreur (AE) et apte à délivrer un courant de sortie dans une charge (RL, CL), dans lequel le dispositif de régulation comprend plusieurs entrées principales d'alimentation (EALPi) destinées à potentiellement recevoir respectivement plusieurs tensions d'alimentation différentes, dans lequel l'étage de puissance (ETP) comprend plusieurs chemins de conduction (PTHi) respectivement connectés entre lesdites entrées principales d'alimentation et ladite borne de sortie, individuellement sélectionnables et comportant chacun un transistor de sortie (MPgi), dans lequel le dispositif de régulation comprend en outre un circuit de sélection (CSL) connecté auxdites entrées principales d'alimentation et configuré pour sélectionner l'un des chemins de conduction (PTHi) en fonction d'un critère de sélection, et en ce que l'amplificateur d'erreur (AE) comporte un étage de sortie (ETS) configuré pour piloter sélectivement le transistor de sortie (MPgi) du chemin de conduction sélectionné, le dispositif de régulation étant **caractérisé en ce que** le circuit de sélection est alimenté par la tension de sortie présente à ladite borne de sortie, et le dispositif possède une configuration de démarrage dans laquelle chaque chemin de conduction connecté à une tension d'alimentation effectivement présente, est passant jusqu'à ce que ladite tension de sortie atteigne une valeur seuil permettant au circuit de sélection (CSL) de sélectionner l'un des chemins de conduction.

2. Dispositif selon la revendication 1, dans lequel l'amplificateur d'erreur (AE) comporte un étage d'entrée (ETE) possédant une entrée (-) couplée à ladite borne de sortie (BS) et l'étage de sortie (ETS) comporte plusieurs modules (MDi) respectivement affectés aux chemins de conduction, chaque module (MDi) étant couplé à la sortie de l'étage d'entrée, à l'entrée principale d'alimentation (EALPi) connectée au chemin de conduction correspondant, et configuré pour piloter ou non le transistor de sortie (MPgi) du chemin de conduction correspondant sur commande du circuit de sélection (CSL).

3. Dispositif selon la revendication 2, dans lequel chaque module (MDi) comporte
une entrée de module (EMDi) couplée à la sortie de l'étage d'entrée (ETE) de l'amplificateur d'erreur,
une sortie de module (SMDi) couplée à la grille du transistor de sortie correspondant,
une entrée d'alimentation de module (EALMi) couplée à l'entrée principale d'alimentation (EALPi) correspondante, et un étage de gain (ETGi) connecté entre l'entrée d'alimentation de module et la masse et comportant un transistor de module (Mfi) connecté entre la sortie de module et la masse et dont la grille est connectée à l'entrée de module et à la masse par l'intermédiaire respectivement de deux interrupteurs (I1i, I2i) respectivement commandables par deux signaux de commande complémentaires délivrés par le circuit de sélection (CSL).

4. Dispositif selon la revendication 3, dans lequel chaque module (MDi) comprend un circuit de compensation de Miller (CCMi) connecté entre le drain et la grille du transistor de module.

5. Dispositif selon la revendication 2, dans lequel chaque module (MDi) est configuré pour, dans ladite configuration de démarrage, rendre passant le transistor de sortie correspondant (MPgi).

6. Dispositif selon la revendication 5, dans lequel chaque transistor de sortie (MPgi) est un transistor PMOS ayant son substrat connecté vers l'entrée principale d'alimentation correspondante (EALPi) et chaque module (MDi) comprend un circuit d'excursion basse (CPDi) connecté entre la sortie de module et la masse et possédant une entrée de commande connecté à ladite borne de sortie.

7. Dispositif selon la revendication 6, dans lequel le circuit d'excursion basse (CPDi) comprend un premier transistor NMOS (Ms1) connecté entre la sortie de module et la masse, une résistance (Rs) connectée entre l'entrée d'alimentation de module et la grille du premier transistor (Msl), un deuxième transistor NMOS (Ms2) connecté entre la grille du premier transistor (Ms1) et la masse et dont la grille est connectée à ladite borne de sortie.

8. Dispositif selon l'une des revendications précédentes, dans lequel chaque chemin de conduction (PTHi) comporte un moyen (MPpi) commandable par le circuit de sélection, configuré pour permettre la sélection ou non du chemin de conduction et pour rendre passant le chemin de conduction pendant la phase de démarrage.

9. Dispositif selon la revendication 8, dans lequel ledit moyen commandable (MPpi) comprend un transistor auxiliaire PMOS (MPpi) ayant son substrat connecté vers la borne de sortie (BS) et sa grille connectée à la borne de sortie (BS) par l'intermédiaire d'une résistance (Ri), le transistor auxiliaire étant connecté entre le transistor de sortie (MPgi) et la borne de sortie (BS), et commandable sur sa grille par l'intermédiaire d'un transistor de commande (TCMi) commandable sur sa grille par le circuit de sélection (CSL).

10. Dispositif selon l'une des revendications précédentes, dans lequel le circuit de sélection comprend plusieurs circuits de détection (CDTi) respectivement couplés aux entrées principales d'alimentation (EALPi) et configurés chacun pour détecter le franchissement d'un seuil par la tension d'alimentation correspondante et délivrer un signal logique de détection (VINi_OK) représentatif du franchissement ou non dudit seuil, et un module logique (MDL) configuré pour recevoir les signaux logiques de détection et pour délivrer un signal de sélection (SELi, SWi) représentatif du chemin de conduction sélectionné en fonction dudit critère de sélection.

11. Dispositif selon l'une des revendications précédentes, dans lequel le critère de sélection correspond à la tension d'alimentation présente présentant la plus faible valeur.

12. Dispositif selon l'une des revendications précédentes, dans lequel l'amplificateur d'erreur (AE) comporte un étage d'entrée (ETE) possédant une entrée (-) couplée à ladite borne de sortie et une entrée d'alimentation connectée à la borne de sortie (BS).

13. Dispositif selon l'une des revendications précédentes, dans lequel l'un au moins des transistors de sortie est un transistor de puissance (MPgl).

14. Contrôleur, compatible avec la norme USB type C, incorporant un dispositif de régulation à faible chute de tension (1) selon l'une des revendications 1 à 13.

15. Appareil incorporant un contrôleur (CTRL) selon la revendication 14.

16. Chargeur de source d'alimentation continue, incorporant un contrôleur (CTRL) selon la revendication 14.

17. Câble USB de type C, incorporant un contrôleur (CTRL) selon la revendication 14.

## Patentansprüche

1. Vorrichtung zum Regulieren mit schwachem Spannungsabfall, einen Fehlerverstärker (AE) und eine Leistungsstufe (ETP) umfassend, die eine Ausgangsklemme (BS) aufweist, die auf den Fehlerverstärker (AE) weitergeschleift ist, und imstande ist, einen Ausgangsstrom in einer Last (RL, CL) zu liefern, wobei die Vorrichtung zum Regulieren mehrere Hauptversorgungseingänge (EALPi) umfasst, die dazu bestimmt sind, möglicherweise jeweils mehrere unterschiedliche Versorgungsspannungen zu empfangen, wobei die Leistungsstufe (ETP) mehrere Leitpfade (PTHi)umfasst, die jeweils zwischen den Hauptversorgungseingängen und der Ausgangsklemme angeschlossen sind, die einzeln auswählbar sind und jeweils einen Ausgangstransistor (MPgi) beinhalten, wobei die Vorrichtung zum Regulieren weiter eine Auswahlschaltung (CSL) umfasst, die an die Hauptversorgungseingänge angeschlossen ist, und konfiguriert ist, um in Abhängigkeit von einem Auswahlkriterium einen der Leitpfade (PTHi) auszuwählen, und dadurch, dass der Fehlerverstärker (AE) eine Ausgangsstufe (ETS) beinhaltet, die konfiguriert ist, um selektiv den Ausgangstransistor (MPgi) des ausgewählten Leitpfades anzusteuern, wobei die Vorrichtung zum Regulieren **dadurch gekennzeichnet ist, dass** die Auswahlschaltung durch die Ausgangsspannung versorgt wird, die in der Ausgangsklemme vorhanden ist, und die Vorrichtung eine Startkonfiguration besitzt, in der jeder Leitpfad, der an eine effektiv vorhandene Versorgungsspannung angeschlossen ist, durchgehend ist, bis die Ausgangsspannung einen Schwellenwert erreicht, der es der Auswahlschaltung (CSL) erlaubt, einen der Leitpfade auszuwählen.

2. Vorrichtung nach Anspruch 1, wobei der Fehlerverstärker (AE) eine Eingangsstufe (ETE) beinhaltet, die einen Eingang (-) besitzt, der an die Ausgangsklemme (BS) gekoppelt ist, und die Ausgangsklemme (ETS) mehrere Module (MDi) beinhaltet, die jeweils den Leitpfaden zugeordnet sind, wobei jedes Modul (MDi) an den Ausgang der Eingangsstufe, an den Hauptversorgungseingang (EALPi), der an den entsprechenden Leitpfad angeschlossen ist, gekoppelt ist, und konfiguriert ist, um den Ausgangstransistor (MPgi) des entsprechenden Leitpfades auf Befehl der Auswahlschaltung (CSL) anzusteuern oder nicht.

3. Vorrichtung nach Anspruch 2, wobei jedes Modul (MDi) beinhaltet
einen Moduleingang (EMDi), der an den Ausgang der Eingangsstufe (ETE) des Fehlerverstärkers gekoppelt ist, einen Modulausgang (SMDi), der an das Gate des entsprechenden Ausgangstransistors gekoppelt ist,
einen Modulversorgungseingang (EALMi), der an den entsprechenden Hauptversorgungseingang (EALPi) gekoppelt ist, und eine Verstärkungsstufe (ETGi), die zwischen dem Modulversorgungseingang und der Masse angeschlossen ist, und einen Modultransistor (Mfi) beinhaltet, der zwischen dem Modulausgang und der Masse angeschlossen ist und dessen Gate über jeweils zwei Schalter (I1i, I2i), die jeweils durch zwei komplementäre Befehlssignale steuerbar ist, die durch die Auswahlschaltung (CSL) abgegeben werden, an den Moduleingang und an die Masse angeschlossen ist.

4. Vorrichtung nach Anspruch 3, wobei jedes Modul (MDi) eine Miller-Kompensationsschaltung (CCMi) umfasst, die zwischen der Drainelektrode und dem Gate des Modultransistors angeschlossen ist.

5. Vorrichtung nach Anspruch 2, wobei jedes Modul (MDi) konfiguriert ist, um in der Startkonfiguration den entsprechenden Ausgangstransistor (MPgi) durchgehend zu machen.

6. Vorrichtung nach Anspruch 5, wobei jeder Ausgangstransistor (MPgi) ein PMOS Transistor ist, dessen Substrat an den entsprechenden Hauptversorgungseingang (EALPi) angeschlossen ist, und jedes Modul (MDi) eine Niederabweichungsschaltung (CPDi) umfasst, die zwischen dem Modulausgang und der Masse angeschlossen ist, und einen Befehlseingang besitzt, der an die Ausgangsklemme angeschlossen ist.

7. Vorrichtung nach Anspruch 6, wobei die Niederabweichungsschaltung (CPDi) einen ersten NMOS-Transistor (Ms1) umfasst, der zwischen dem Modulausgang und der Masse angeschlossen ist, einen Widerstand (Rs), der zwischen dem Modulversorgungseingang und dem Gate des ersten Transistors (Ms1) angeschlossen ist, einen zweiten NMOS-Transistor (Ms2), der zwischen dem Gate des ersten Transistors (Ms1) und der Masse angeschlossen ist, und dessen Gate an die Ausgangsklemme angeschlossen ist.

8. Vorrichtung nach einem der vorstehenden Ansprüche, wobei der Leitpfad (PTHi) ein durch die Auswahlschaltung steuerbares Mittel (MPpi) beinhaltet, das konfiguriert ist, um die Auswahl des Leitpfades zu erlauben oder nicht, und um den Leitpfad während der Startphase durchgehend zu machen.

9. Vorrichtung nach Anspruch 8, wobei das steuerbare Mittel (MPpi) einen PMOS-Hilfstransistor (MPpi) umfasst, dessen Substrat an der Ausgangsklemme (BS) angeschlossen ist, und dessen Gate über einen Widerstand (Ri) an die Ausgangsklemme (BS) angeschlossen ist, wobei der Hilfstransistor zwischen dem Ausgangstransistor (MPgi) und der Ausgangsklemme (BS) angeschlossen ist, und auf seinem Gate über einen Steuerungstransistor (TCMi), der auf seinem Gate durch die Auswahlschaltung (CSL) steuerbar ist, steuerbar ist.

10. Vorrichtung nach einem der vorstehenden Ansprüche, wobei die Auswahlschaltung mehrere Detektionsschaltungen (CDTi) umfasst, die jeweils an die Hauptversorgungseingänge (EALPi) gekoppelt sind, und jeweils konfiguriert sind, um die Überschreitung einer Schwelle durch die entsprechende Versorgungsspannung zu detektieren und ein logisches Detektionssignal (VINi_OK) der Überschreitung der Schwelle oder nicht abzugeben, und ein Logikmodul (MDL), das konfiguriert ist, um die logischen Detektionssignale zu empfangen, und um ein für den Leitpfad, der in Abhängigkeit von dem Auswahlkriterium Auswahlsignal ausgewählt wird, repräsentatives Auswahlsignal (SELi, SWi) abzugeben.

11. Vorrichtung nach einem der vorstehenden Ansprüche, wobei das Auswahlkriterium der vorhandenen Versorgungsspannung entspricht, die den geringsten Wert aufweist.

12. Vorrichtung nach einem der vorstehenden Ansprüche, wobei der Fehlerverstärker (AE) eine Eingangsstufe (ETE) beinhaltet, die einen Eingang (-) besitzt, der an die Ausgangsklemme gekoppelt ist und einen Versorgungseingang, der an die Ausgangsklemme (BS) angeschlossen ist.

13. Vorrichtung nach einem der vorstehenden Ansprüche, wobei mindestens einer der Ausgangstransistoren ein Leistungstransistor (MPg1) ist.

14. Controller, der mit der USB-Norm Typ C kompatibel ist, der eine Vorrichtung zum Regulieren mit schwachem Spannungsabfall (1) nach einem der Ansprüche 1 bis 13 beinhaltet.

15. Einrichtung, die einen Controller (CTRL) nach Anspruch 14 beinhaltet.

16. Gleichstromquellen-Ladegerät, das einen Controller (CTRL) nach Anspruch 14 beinhaltet.

17. USB-Kabel vom Typ C, das das einen Controller (CTRL) nach Anspruch 14 beinhaltet.

## Claims

1. A low drop out regulator, comprising an error amplifier (AE) and a power stage (ETP) having an output terminal (BS) looped back on the error amplifier (AE) and capable of delivering an output current in a load (RL, CL), wherein the regulator comprises several main power inputs (EALPi) intended to potentially receive respectively several different power voltages, wherein the power stage (ETP) comprises several conduction paths (PTHi) respectively connected between said main power inputs and said output terminal, individually selectable and each including an output transistor (MPgi), wherein the regulator further comprises a selection circuit (CSL) connected to said main power inputs and configured to select one of the conduction paths (PTHi) depending on a selection criterion, and in that the error amplifier (AE) includes an output stage (ETS) configured to selectively drive the output transistor (MPgi) of the selected conduction path, the regulator being **characterised in that** the selection circuit is powered by the output voltage present at said output terminal, and the device has a starting configuration wherein each conduction path connected to a power voltage actually present is on until said output voltage reaches a threshold value allowing the selection circuit (CSL) to select one of the conduction paths.

2. The device according to claim 1, wherein the error amplifier (AE) includes an input stage (ETE) having an input (-) coupled to said output terminal (BS) and the output stage (ETS) includes several modules (MDi) respectively assigned to the conduction paths, each module (MDi) being coupled to the output of the input stage, to the main power input (EALPi) connected to the corresponding conduction path, and configured to drive or not the output transistor (MPgi) of the corresponding conduction path under control of the selection circuit (CSL).

3. The device according to claim 2, wherein each module (MDi) includes
a module input (EMDi) coupled to the output of the input stage (ETE) of the error amplifier,
a module output (SMDi) coupled to the gate of the corresponding output transistor,
a module power input (EALMi) coupled to the corresponding main power input (EALPi), and a gain stage (ETGi) connected between the module power input and the ground and including a module transistor (Mfi) connected between the module output and the ground and whose gate is connected to the module input and to the ground via respectively two switches (I1i, I2i) respectively controllable by two complementary control signals delivered by the selection circuit (CSL).

4. The device according to claim 3, wherein each module (MDi) comprises a Miller compensation circuit (CCMi) connected between the drain and the gate of the module transistor.

5. The device according to claim 2, wherein each module (MDi) is configured, in said starting configuration, to turn on the corresponding output transistor (MPgi).

6. The device according to claim 5, wherein each output transistor (MPgi) is a PMOS transistor having its substrate connected to the corresponding main power input (EALPi) and each module (MDi) comprises a pull down circuit (CPDi) connected between the module output and the ground and having a control input connected to said output terminal.

7. The device according to claim 6, wherein the pull down circuit (CPDi) comprises a first NMOS transistor (Msl) connected between the module output and the ground, a resistor (Rs) connected between the module power input and the gate of the first transistor (Msl), a second NMOS transistor (Ms2) connected between the gate of the first transistor (Msl) and the ground and whose gate is connected to said output terminal.

8. The device according to one of the preceding claims, wherein each conduction path (PTHi) includes a means (MPpi) controllable by the selection circuit, configured to allow the selection or not of the conduction path and to turn on the conduction path during the starting phase.

9. The device according to claim 8, wherein said controllable means (MPpi) comprises an auxiliary PMOS transistor (MPpi) having its substrate connected to the output terminal (BS) and its gate connected to the output terminal (BS) via a resistor (Ri), the auxiliary transistor being connected between the output transistor (MPgi) and the output terminal (BS), and controllable on its gate via a control transistor (TCMi) controllable on its grid by the selection circuit (CSL).

10. The device according to one of the preceding claims, wherein the selection circuit comprises several detection circuits (CDTi) respectively coupled to the main power inputs (EALPi) and each configured to detect the crossing of a threshold by the corresponding power voltage and deliver a logic detection signal (VINi_OK) representative of the crossing or not of said threshold, and a logic module (MDL) configured to receive the logic detection signals and to deliver a selection signal (SELi, SWi) representative of the conduction path selected depending on said selection criterion.

11. The device according to one of the preceding claims, wherein the selection criterion corresponds to the present power voltage having the lowest value.

12. The device according to one of the preceding claims, wherein the error amplifier (AE) includes an input stage (ETE) having an input (-) coupled to said output terminal and a power input connected to the output terminal (BS).

13. The device according to one of the preceding claims, wherein at least one of the output transistors is a power transistor (MPgl).

14. A controller, compatible with type C USB standard, incorporating a low drop out regulator (1) according to one of claims 1 to 13.

15. An apparatus incorporating a controller (CTRL) according to claim 14.

16. A continuous power source charger, incorporating a controller (CTRL) according to claim 14.

17. A type C USB cable, incorporating a controller (CTRL) according to claim 14.
